# EUROPÄISCHE PATENTANMELDUNG

(11) **EP 1 347 490 A2**
(43) Veröffentlichungstag der Anmeldung: **24.09.2003**
(21) Anmeldenummer: 03005914.1
(22) Anmeldetag: 17.03.2003
(51) Int. Cl.: H01J 37/28

(54) **Blenden-Zusatzvorrichtung für ein Rasterelektronenmikroskop**

(30) Priorität: 18.03.2002 DE 10211977
(71) Anmelder: LEO Elektronenmikroskopie GmbH, 73446 Oberkochen (DE)
(72) Erfinder: Golla-Schindler, Ute, Dr., 73434 Aalen (DE); Schindler, Bernd, Dr., 73434 Aalen (DE)
(74) Vertreter: Gnatzig, Klaus

(57) **Zusammenfassung**

Die Erfindung betrifft ein Rasterelektronenmikroskop mit einer Probenkammer (2) und einem in der Probenkammer angeordneten Detektor (23-25) für Elektronen und einem in der Probenkammer angeordneten Probentisch (16) mit einem Probenhalter, wobei am Probentisch ein relativ zum Probenhalter justierbares Blendensystem (15,18-21) mit einer Blende (19-21) zwischen dem Probenhalter und dem Detektor vorgesehen ist.

Die Erfindung kann insbesondere als Zusatzmodul, das auf den Probentisch eines konventionellen Rasterelektronenmikroskops aufnehmbar ist, ausgebildet sein. Das System aus Rasterelektronenmikroskop und Zusatzeinheit dient zur Erzeugung besonderer Kontrastierungen, insbesondere einem Dunkelfeldkontrast in Transmission.

## Beschreibung

Rasterelektronenmikroskope weisen in der Regel in der Probenkammer einen oder mehrere Detektoren zum Nachweis der von dem Primärelektronenstrahl aus der Probe ausgelösten Sekundär- und/oder Rückstreuelektronen ( BSE) auf. Je nach dem, ob für die Bilderzeugung die Intensität der Rückstreuelektronen oder die der Sekundärelektronen (SE) zugrunde gelegt wird, wird eine unterschiedliche Kontrastierung des Probenbildes erzeugt.

In dem Aufsatz in Journal of Microscopy, Vol 173, (1999), Seiten 219-225 ist eine Anordnung beschrieben, mit der mit einem üblichen Rasterelektronenmikroskop die Bilderzeugung auf Basis der durch die Probe transmittierten Elektronen möglich ist. Die Anordnung enthält eine zylinderförmige Abschirmeinheit, die auf dem Probentisch aufgenommen ist und in deren Inneren der Probenhalter aufgenommen ist. Die Abschirmeinheit sorgt dafür, dass keine auf der Einfallsseite des Elektronenstrahls aus der Probe austretenden Elektronen zu dem Detektor gelangen können. Die Abschirmeinheit schließt sich dazu unmittelbar an den unteren Polschuh der Objektivlinse des Rasterelektronenmikroskops an. Die mit dieser Anordnung mögliche Kontrastierung entspricht einem Hellfeldkontrast in Transmission und ermöglicht nur die Detektion von Signalen des zentralen Bereiches der Probe, weil der Bereich, von dem aus der Probe austretende Elektronen den Detektor erreichen können, durch den Blendendurchmesser begrenzt ist.

Die Erzeugung von Bildern im Dunkelfeld-Kontrast in der Elektronenmikroskopie ist bisher den sogenannten Raster-Tansmissions-Elektronenmikroskopen (STEM) vorbehalten. Bei diesen STEMs handelt es sich um Transmissionselektronenmikroskope mit einem in der Regel mehrstufigen Kondensorsystem zwischen der Elektronenquelle und der Probe und einem in der Regel ebenfalls mehrstufigen elektronenoptischen Abbildungssystem mit dem die Probe vergrößert in eine Detektionsebene abgebildet wird. Im STEM-Modus wird das Kondensorsystem dann so angesteuert, dass es die Elektronenquelle verkleinert auf die Probe abbildet.

Da im Transmissionselektronenmikroskop die Probenebene üblicher Weise auf der Höhe des Polschuhspaltes einer sowohl als letzte Kondensorlinse als auch als Objektivlinse wirkenden Kondensor-Objektiv-Einfeldlinse liegt, sind mit Transmissionselektronenmikroskopen keine Untersuchungen mit geneigten Proben möglich, bei denen die Probenoberfläche zur optischen Achse des einfallenden Primärelektronenstrahls geneigt ist - d.h. die Oberflächennormale der Probe unter einem Winkel zur optischen Achse von 30° oder mehr steht. Derartige Probenneigungen sind bisher nur in Rasterelektronenmikroskopen realisierbar.

Ziel der vorliegenden Erfindung ist es, ein Rasterelektronenmikroskop anzugeben, mit dem die Erzeugung von Probenbildern in Transmission mit unterschiedlichen Kontrastierungen möglich ist. Die Erfindung sollte dabei in der Form einer in der Probenkammer aufzunehmenden Zusatzeinheit für Rasterelektronenmikroskope ausgebildet sein. Dieses Ziel wird erfindungsgemäß mit einem Rasterelektronenmikroskop mit den Merkmalen des Anspruche 1 und durch eine Zusatzeinrichtung mit den Merkmalen des Anspruches 12 oder 13 gelöst. Vorteilhafte Ausführungsformen der Erfindung ergeben sich aus den Merkmalen der abhängigen Ansprüche.

Das erfindungsgemäße Rasterelektronenmikroskop weist wie üblich eine Probenkammer und einen in der Probenkammer angeordneten Detektor für Elektronen sowie einen in der Probenkammer angeordneten Probentisch mit einem Probenhalter auf. Am Probentisch ist ein relativ zum Probenhalter justierbares Blendensystem mit einer Blende zwischen dem Probenhalter und dem Detektor aufgenommen.

Mit Hilfe der relativ zum Probenhalter justierbaren Blende ist die Kontrastierung der Bildaufnahme veränderbar. Ist beispielsweise die Blende so ausgelegt und justiert, dass die nahe an der optischen Achse des Rasterelektronenmikroskopes verlaufenden, durch die Probe transmittierten Elektronen ausgeblendet werden, tragen nur die in größere Winkel gestreuten Elektronen zur Bilderzeugung bei und das Ergebnis entspricht einem Dunkelfeld-Kontrast. Diese Kontrastierung erhöht z.B. den Kontrast bei Proben mit Z-Kontrast oder kristallinen Proben mit Gitterbaufehlern oder Ordnungsfehlern oder Proben mit Phasenübergängen. Ist hingegen die Blende so ausgebildet und justiert, dass gerade die nahe zur und nur mit einem geringen Winkel zur optischen Achse aus der Probe austretenden Elektronen durch die Blende transmittieren und dadurch zur Bilderzeugung beitragen, entspricht die Kontrastierung einem Hellfeld-Kontrast.

Durch Verschieben des Probentisches einschließlich der daran aufgenommenen Abschirmeinheit senkrecht zur optischen Achse des Rasterelektronenmikroskopes und simultanes Verstellen der Blende in umgekehrter Richtung können sukzessive Bilder von größeren Probenbereichen oder sogar von der ganzen Probe mit der gewünschten Kontrastierung erzeugt werden.

Der Probenhalter ist vorzugsweise in einer Abschirmeinheit angeordnet und die Blende an der vom Probenhalter abgewandeten Seite an der Abschirmeinheit aufgenommen. Die Abschirmeinheit sorgt dann dafür, dass nur diejenigen aus der Probe austretenden Elektronen zum Detektor gelangen können, die die Blendenöffnung passiert haben. Eine entsprechende Abschirmeinheit kann als ein für Elektronen undurchlässiges, zylindrisches Rohr ausgebildet sein, wobei es auf die Querschnittsform des Rohres nicht ankommt. Auf der zum Objektiv gewandten Seite sollte der Abschirmkörper einen Ring aufweisen, mit dem der unmittelbar auf den Polschuh des Objektivs folgende Bereich gegen Austritt von Elektronen abgedichtet wird, um so zu verhindern, dass rückwärts gestreute Elektronen oder von der vom Primärelektronenstrahl bestrahlten Probenfläche austretende Sekundärelektronen den Detektor erreichen können.

Der Detektor kann für den Nachweis von Sekundärelektronen und/oder für den Nachweis von Elektronen, die eine Energie vergleichbar zur Energie der Primärelektronen aufweisen, ausgebildet sein.

Besonders bevorzugt weist der Detektor ein Konversionselement auf, das bei Bestrahlung mit Elektronen Sekundärelektronen mit einer Ausbeute größer 1 emittiert. Dieses Konversionselement ist vorzugsweise unmittelbar hinter der Blende angeordnet, so dass sämtliche durch die Blendenöffnung transmittierten Elektronen auf dieses Konversionselement einfallen.

Das Blendensystem weist vorzugsweise mehrere wahlweise zwischen dem Probenhalter und dem Detektor einbringbare Blenden mit unterschiedlichen Blendenöffnungen auf. Dadurch ist die Art der Kontrastierung einfach änderbar. Besonders bevorzugt sollte ein motorischer Antrieb für den Blendenwechsel vorgesehen sein, so dass kein manueller Eingriff in der Probenkammer erforderlich ist. Bei hinreichend großen Verstellwegen der Antriebe für die Blendenjustierung können auch diese Antriebe gleichzeitig für eine Blendenschaltung genutzt werden.

Für die Erzeugung von Dunkelfeld-Kontrast sollte die Blende oder eine der Blenden einen zentralen für Elektronen undurchlässigen Bereich aufweisen.

Der Probenhalter ist vorzugsweise um eine zur optischen Achse des Rasterelektronenmikroskopes senkrechte Achse kippbar, wobei auch Kippwinkel von 30° und mehr zwischen der Oberflächennormale des Probenhalters und der optischen Achse möglich sein sollten.

Die Erfindung kann insbesondere als Zusatzeinheit für ein Rasterelektronenmikroskop ausgebildet sein. Eine solche Zusatzeinheit weist eine auf einem Probentisch aufnehmbare zylindrische Abschirmeinheit, einen im inneren der Abschirmeinheit angeordneten Probenhalter und einen die Abschirmeinheit auf der dem Probentisch zugewandten Seite abschließenden, relativ zum Probenhalter justierbaren Blendenhalter mit einer Blende auf. Mit Hilfe einer solchen Zusatzeinheit und der für die Justierantriebe des Blendehalters erforderlichen Ansteuerungen ist auf einfache Weise mit üblichen Rasterelektronenmikroskopen die Erzeugung von Dunkelfeldkontrastbildern in Transmission möglich.

Bei einer alternativen Zusatzeinrichtung umgibt eine Abschirmeinheit den Elektronendetektor und die Eintrittsöffnung der Abschirmeinheit ist durch eine auswechselbare Blende verschlossen. An der Abschirmeinheit ist dann weiterhin ein Probenhalter aufgenommen, der relativ zur Blende bzw. relativ zu dem Blendenhalter justierbar ist.

In einer weiterhin vorteilhaften Ausführungsform ist zwischen dem Probenhalter und Blendensystem oder zwischen dem Blendensystem und dem Detektor ein Energiefilter vorgesehen. Dadurch lässt sich dann zusätzlich erreichen, dass nur durch die Probe transmittierte Elektronen mit einer bestimmten Energie zum Detektor gelangen können, so dass sich eine zusätzliche Kontrastierungsmöglichkeit ergibt. Ein entsprechendes Energiefilter kann im einfachsten Fall als eine Gegenfeldelektrode ausgebildet sein. Alternativ ist es natürlich auch möglich, komplexere magnetische oder elektrostatische Energiefilter oder Spektrometer, wie sie aus dem Stand der Technik bekannt sich, einzusetzen.

Nachfolgend werden weitere Einzelheiten der Erfindung anhand der in den Figuren dargestellten Ausführungsbeispiele näher erläutert. Dabei zeigen:
- Figur 1: die Prinzipskizze eines erfindungsgemäßen Rasterelektronenmikroskops im Schnitt;
- Figur 2: die Prinzipskizze einer alternativen Ausführungsform der Erfindung im Schnitt;
- Figur 3: die Prinzipskizze eines erfindungsgemäßen Rasterelektronenmikroskops mit einem Energiefilter im Schnitt

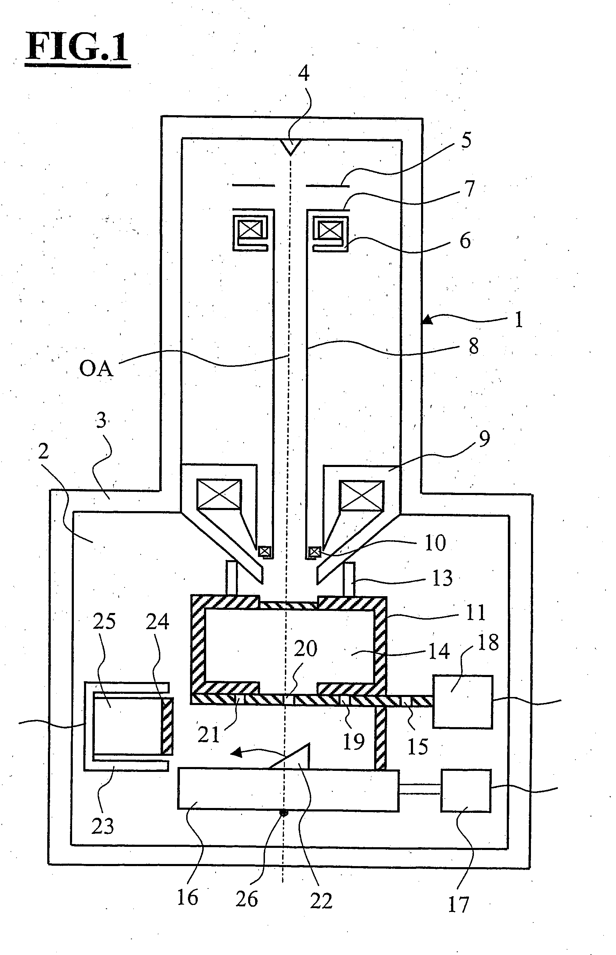

In der Figur 1 ist mit (1) die Säule eines Rasterelektronenmikroskops und mit (2) dessen Probenkammer bezeichnet. Das Rasterelektronenmikroskop selbst kann einen konventionellen Aufbau mit einer als Elektronenquelle dienenden Kathode (4), einer darauf folgenden Extraktionselektrode (5) und einer Beschleunigungselektrode (6) aufweisen, mit der aus der Kathode (4) austretenden Elektronen auf ihre Säulenenergie beschleunigt werden.

Auf den Elektronenstrahlerzeuger folgt eine magnetische Kondensorlinse (6) durch die die Apertur des Elektronenstrahls eingestellt wird, und eine Objektivlinse (9). Die Objektivlinse kann eine rein magnetische Linse mit einer Spule und einem Polschuh oder die Kombination aus einer elektrostatischen und einer magnetischen Linse sein. Im dargestellten Ausführungsbeispiel ist noch ein Strahlführungsrohr (8) vorgesehen, das von der Anode (7) entlang der optischen Achse(OA) bis auf die Höhe des Polschuhspaltes der Objektivlinse (9) reicht und bei Bedarf auf einem vom Probenpotential abweichenden Potential liegt. Dadurch wird dann durch das elektrostatische Verzögerungsfeld zwischen dem Austritt aus dem Strahlführungsrohr und der Probe eine elektrostatische Linse gebildet, die der vom Magnetfeld der Objektivlinse erzeugten Linsenwirkung zumindest teilweise räumlich überlagert ist.

Auf der Höhe des Polschuhspaltes der Objektivlinse (9) sind weiterhin die Spulen eines Ablenksystems (10) angeordnet, durch die der von der Objektivlinse (9) erzeugte Elektronenfokus senkrecht zur optischen Achse (OA) zum Abrastern der Probe auslenkbar ist.

Innerhalb der Probenkammer (2) ist ein SEM-Probentisch (16) angeordnet, der in den drei Raumrichtungen, also sowohl senkrecht als auch parallel zur optischen Achse (OA) motorisch verschiebbar ist und zusätzlich um eine senkrecht zur optischen Achse (OA) stehende Achse (26) kippbar ist.

Auf dem Probentisch (16) ist die erfindungsgemäße Zusatzeinheit aufgenommen. Sie besteht aus einem zylindrischen Grundkörper (11) mit einem erweiterten, bauchigen Innenraum (14), und jeweils zwei koaxial zueinander angeordneten Öffnungen, jeweils einer Öffnung an jedem Ende des zylindrischen Grundkörpers (11). Die dem Objektiv (9) zugewandte Öffnung ist mit einem Probenhalter versehen, wie er sonst in Transmissionselektronenmikroskopen als Probenhalter eingesetzt wird. Objektivseitig schließt sich an den Grundkörper (11) ein die objektivseitige Öffnung koaxial umgebender Abschirmring (13) an, der den Zwischenraum zwischen dem austrittsseitigen Ende der Objektivlinse (9) und der Probe weitgehend verschließt. Damit auch bei einem gekippten Probentisch kein Zwischenraum zwischen der Objektivlinse und dem Grundkörper (11) auftritt, kann der Abschirmring als Metallbalg ausgebildet sein.

Auf der dem Objektiv (9) abgewandten Seite schließt sich an den Grundkörper (11) ein Blendenhalter (15) mit einer darin aufgenommenen Blende mit mehreren Blendenöffnungen (19, 20, 21) an. Die Position der Blendenöffnungen relativ zur optischen Achse (OA) ist über Piezoantriebe in beiden Richtungen senkrecht zu optischen Achse (OA) justierbar. Außerdem sind die Blenden motorisch schaltbar, d.h. es kann jede der drei Blendenöffnungen wahlweise in eine Position geschaltet werden, so dass die Blendenöffnung auf der optische Achse (OA) liegt. Der motorische Antrieb für die Blendenschaltung und für die Justierung der Blenden ist in der Figur 1 mit (18) angedeutet. Die Antriebe für den Objekttisch (16) sind in der Figur 1 mit (17) angedeutet.

Bei der in der Figur 1 dargestellten Ausführungsform sind nur drei unterschiedliche Blendenöffnungen vorgesehen. Es ist jedoch auch möglich, ein weit größere Anzahl - z.B. 20 - unterschiedlicher Blendenöffnungen vorzusehen, von denen dann ein Teil ähnliche Formen jedoch unterschiedliche Dimensionen der Öffnungen aufweisen, so dass Zwischenformen der verschiedenen Kontrastierungen realisiert werden können oder die Blendengröße in Abhängigkeit von den jeweiligen individuellen Probeneigenschaften und die daraus resultierenden zu detektierenden Signalstärken gewählt werden können.

Von den Blenden (19, 20, 21) für eine Dunkelfeldkontrastierung hat mindestens eine Blende (20) einen für Elektronen undurchlässigen zentralen Bereich, d. h. die Blendenöffnung ist ringförmig.

Weiterhin ist auf dem Probentisch (16) ein prismenförmiges Konversionselement (22) aufgenommen. Das Konversionselement (22) besteht aus einem Material hoher Ordnungszahl, z.B. Kupfer, Messing oder Gold, und hat die Eigenschaft, dass es bei Beschuß mit Elektronen mehr Elektronen wieder abgibt als eingefallen sind.

Weiterhin ist in der Probenkammer (2) ein Elektronendetektor angeordnet, der in dem dargestellten Ausführungsbeispiel als Everhard-Thornley-Detektor ausgebildet ist und eine Beschleunigungselektrode (23), und einen mit einem Szintillator (24) versehenen Glasstab (25) aufweist.

Mit der zuvor beschriebenen Anordnung werden die aus der Elektronenquelle austretenden Elektronen vom Objektiv (9) auf eine auf dem Probenhalter (12) aufzunehmende Probe fokussiert. Durch den Abschirmring (13) wird sicher gestellt, dass keine objektivseitig aus der Probe austretenden Elektronen - Rückstreuelektronen oder Sekundärelektronen - zum Detektor (23, 24, 25) gelangen können.

Durch die Blende an der unteren, vom Objektiv abgewandten Seite des Grundkörpers (11) wird sicher gestellt, dass nur solche Elektronen zur Bilderzeugung beitragen, die die in den Strahlengang eingeschaltete Blendenöffnung (19, 20, 21) passiert haben. Ist die Blende (20) mit dem für Elektronen undurchlässigen zentralen Bereich eingeschaltet, ist die Konsequenz, dass nur solche Elektronen durch diese Blende hindurch auf das Konversionselement treffen, die an der Probe unter einem entsprechenden Winkel gestreut wurden. Alle übrigen Elektronen, die unter einem zu kleinen Winkel oder unter einem zu großen Winkel gestreut wurden, werden entweder von der Wand des Grundkörpers (11) oder vom undurchlässigen Bereich der Blende absorbiert. Die bauchige Ausbildung des Grundkörpers dient daher auch als Strahlfalle für zu stark an der Probe gestreute Elektronen.

Die Elektronen, die die eingeschaltete Blende passiert haben, werden vom Konversionselement durch Sekundärelektronenemission geringfügig verstärkt und nachfolgend werden aus dem Konversionselement austretenden Elektronen vom Detektor (23, 24, 25) erfasst. Zur Erzeugung eines vollständigen Bildes der Probe wird sequentiell der Primärelektronenstrahl mit Hilfe des Ablenksystems (10) über die Probe gescannt und jeweils synchron zum Scannen mit dem Detektor das jeweilige Signal erfasst und so sukzessiv das gesamte Bild aufgebaut. Die Blende wird bei diesem Scannen des Primärelektronenstrahls ortsfest gehalten. Um auch größere Probenfelder zu erfassen, kann die Probe jeweils nach Aufzeichnung eines Teilbildes durch Verschieben des Probentisches verschoben werden und gleichzeitig die Blende in umgekehrter Richtung relativ zum Grundkörper (11) verschoben werden.

Je nach Wahl und Justierung der in den Strahlengang eingeschalteten Blende lassen sich so unterschiedliche Kontrastierungen erzeugen, insbesondere ein Dunkelfeldkontrast, wenn in den Strahlengang die Blende mit für Elektronen undurchlässigem zentralen Bereich eingeschaltet ist.

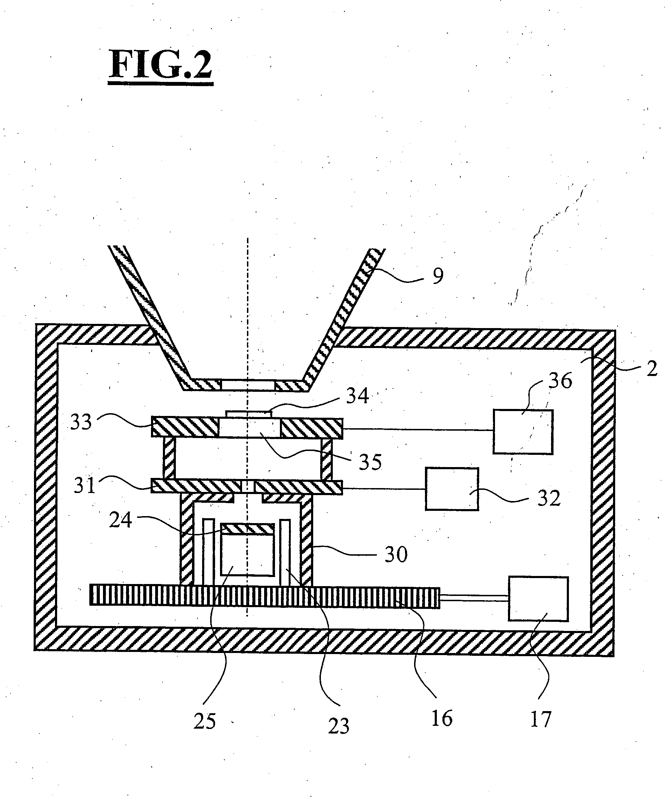

Die Ausführungsform in Figur 2 entspricht hinsichtlich des Rasterelektronenmikroskopes der Ausführungsform in Figur 1, weshalb in so weit auf die obige Beschreibung zur Figur 1 verwiesen sei.

Bei dieser alternativen Ausführungsform ist der Detektor, der wiederum als Szintillationsdetektor (23, 24, 25) ausgebildet sein kann, unmittelbar auf dem SEM Probentisch (16) aufgenommen. Der Detektor ist von einer zylindrisch Abschirmeinheit (30) mit einer objektivseitigen Eintrittsöffnung umgeben. Der Blendenhalter (31), der mehrere Blenden mit unterschiedlichen Öffnungen enthält, verschließt die Eintrittsöffnung der Abschirmeinheit. Im Unterschied zur Ausführungsform in Figur 1 ist der Blendenhalter (31) in dieser Ausführungsform nicht justierbar sondern lediglich schaltbar, so dass eine der Blendenöffnungen in die mittlere Schaltposition geschaltet werden kann, so dass sie über der Öffnung in der Abschirmeinheit liegt. Die Justierung der Blende relativ zur optischen Achse des Elektronenmikroskops erfolgt über die Antriebe des Probentisches (16).

Objektivseitig des Blendhalters ist, gegenüber den übrigen Bauteilen und insbesondere dem Blendenhalter justierbar, der Probenhalter (33) aufgenommen. Der Probenhalter (33) ist dabei über Piezoantriebe (36) senkrecht zur optischen Achse (OA) relativ zum Blendhalter justierbar. Die Erzeugung des gewünschten Kontrastes erfolgt bei dieser Ausführungsform über eine Justierung der Probe relativ zur Blende.

Durch die Verwendung des Szintillationsdetektors ist bei dieser zweiten Ausführungsform ein besseres Signal zu Rausch Verhältnis realisieren.

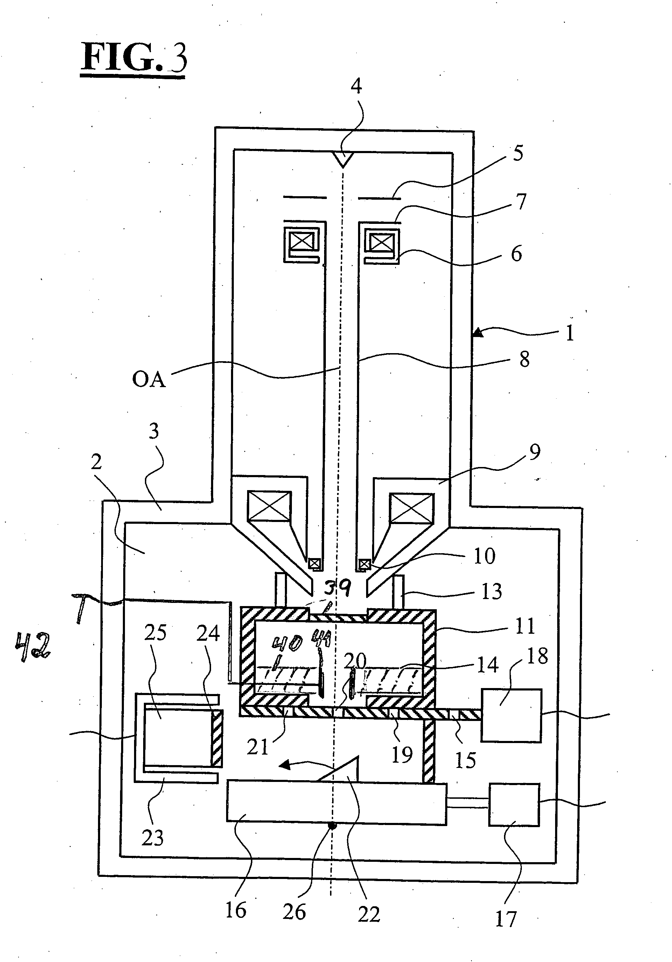

In der Figur 3 sind die den Komponenten der Ausführungsform in Figur 1 entsprechenden Komponenten mit den selben Bezugszeichen versehen. Zusätzlich zu den bereits im Zusammenhang mit der Ausführungsform in Figur 1 beschriebenen Komponenten weist die in der Probenkammer (2) mit dem Probenkammer-Gehäuse (3) angeordnete Zusatzeinheit zwischen dem Probenhalter (39) und dem Blendenhalter (15) mit den Blendenöffnungen (19, 20, 21) ein Energiefilter auf. Das in dieser Ausführungsform realisierte Energiefilter besteht aus einer zylindrischen Elektrode (41), die koaxial zum zylindrischen Grundkörper (15) in dessen Inneren an einem Isolator aufgenommen ist. Über eine Leitung (42) kann die zylindrische Elektrode (41) mittels einer nicht dargestellten Hochspannungsquelle mit einem negativen Potential gegenüber dem Potential des Grundkörpers (11) beaufschlagt werden, das die durch die Probe transmittierten Elektronen abbremst. Dadurch lässt sich erreichen, das nur solche Elektronen, deren kinetische Energie höher als die durch das Potential der zylindrischen Elektrode definierte Energie ist, die Blendenöffnungen (19, 20, 21) erreichen und diese passieren können. Dadurch lässt sich z.B. erreichen, das nur solche Elektronen zur Signalerzeugung beitragen, die keinen Energieverlust oder nur einen maximalen Energieverlust beim Durchtritt durch die Probe erfahren haben. Das maximal an die zylindrische Elektrode (20) anlegbare Potential sollte deshalb dem inversen Anodenpotential des Elektronenmikroskops entsprechen.

Wenn eine genauere Einstellung der Energie erforderlich sein sollte, kann anstelle einer einfachen Gegenfeldlinse, die durch die mit Potential beaufschlagte zylindrische Elektrode (20) gebildet wird, auch ein geradsichtiges magnetisches oder elektrostatisches Spektrometer oder Energiefilter zum Einsatz kommen, wie dieses beispielsweise in der US 6, 384,412 beschrieben ist. Gegebenenfalls kann das Energiefilter auch eintrittsseitig, d.h. auf der dem Probenhalter (39) zugewandten Seite, eine Eintrittsblende aufweisen.

Alternativ zu der beschriebenen Anordnung des Energiefilters zwischen dem Probenhalter (39) und dem Blendenhalter (15) im Inneren des Grundkörpers (11) kann das Energiefilter - in beliebiger der angesprochenen Realisierungsformen - auch zwischen dem Blendenhalter (15) und dem Probentisch (16), also in Ausbreitungsrichtung der Elektronen gesehen hinter der Blendenöffnung (19, 20, 21) angeordnet sein, wenn dadurch der Weg der Elektronen zum Detektor nicht versperrt wird, wie dieses bei der Ausführungsform in Figur 2 der Fall ist. Dieses lässt sich beispielsweise dadurch realisieren, wenn in der Ausführungsform in Figur (2) innerhalb des Grundkörpers (30) zwischen dem Blendenhalter (31) und dem Detektor (23, 24, 25) eine gegenüber dem Potential des Grundkörpers (30) auf negativem Potential liegende Gegenfeldelektrode angeordnet ist.

Die Anordnungen mit einem zusätzlichen Energiefilter ermöglichen eine Kontrastierung, die sowohl von der Energie der vom Energiefilter durchgelassenen Elektronen als auch vom Streuwinkel, der durch die eingeschaltete Blendenöffnung definiert ist, abhängt.

Bei den beschrieben Ausführungsformen ist jeweils nur ein einziger Probenhalter vorgesehen. Es ist natürlich auch möglich, mehrere Probenhalter auf einem Träger anzuordnen, der um eine zur optischen Achse des Elektronenmikroskops parallele aber versetzte Achse wie ein Karussel oder Revolver drehbar ist, so dass mehrere Proben nacheinander analysiert werden können, indem nacheinander ein Probenhalter nach dem anderen über eine der Blendenöffnungen (19, 20, 21) positioniert wird.

## Patentansprüche

1. Rasterelektronenmikroskop mit einer Probenkammer und einem in der Probenkammer angeordneten Detektor für Elektronen und einem in der Probenkammer angeordneten Probentisch mit einem Probenhalter, wobei am Probentisch ein relativ zum Probenhalter justierbares Blendensystem mit einer Blende zwischen dem Probenhalter und dem Detektor vorgesehen ist.

2. Rasterelektronenmikroskop nach Anspruch 1, wobei der Probenhalter in einer Abschirmeinheit angeordnet ist und die Blende an der vom Probenhalter abgewandeten Seite an der Abschirmeinheit aufgenommen ist.

3. Rasterelektronenmikroskop nach Anspruch 2, wobei die Abschirmeinheit als ein für Elektronen undurchlässiges zylindrisches Rohr ausgebildet ist.

4. Rasterelektronenmikroskop nach einem der Ansprüche 1 bis 3, wobei der Detektor für den Nachweis von Sekundärelektronen ausgebildet ist.

5. Rasterelektronenmikroskop nach einem der Ansprüche 1 bis 3, wobei der Detektor für den Nachweis von Elektronen einer der Primärelektronenenergie annähernd entsprechenden Energie ausgebildet ist.

6. Rasterelektronenmikroskop nach Anspruch 4, wobei der Detektor ein Konversionselement aufweist, das bei Bestrahlung mit Elektronen Sekundäreletronen mit einer Ausbeute größer 1 emittiert.

7. Rasterelektronenmikroskop nach einem der Ansprüche 1 bis 6, wobei das Blendensystem mehrere wahlweise zwischen dem Probenhalter und dem Detektor einbringbare Blenden mit unterschiedlichen Blendenöffnungen aufweist.

8. Rasterelektronenmikroskop nach einem der Ansprüche 1 bis 7, wobei die Blende oder eine der Blenden einen zentralen für Elektronen undurchlässigen Bereich aufweist.

9. Rasterelektronenmikroskop nach einem der Ansprüche 1 bis 8, wobei der Probentisch um eine zur optischen Achse des Rasterelektronenmikroskopes senkrechte Achse kippbar ist.

10. Rasterelektronenmikroskop nach einem der Ansprüche 1 bis 9, wobei zusätzlich ein Energiefilter (41) zwischen dem Probenhalter (39) und dem Detektor (23, 24, 25) vorgesehen ist.

11. Rasterelektronenmikroskop nach Anspruch 10, wobei das Energiefilter als eine mit einem negativen Potential beaufschlagbare Elektrode (41) ausgebildet ist.

12. Zusatzeinheit für ein Rasterelektronenmikroskop mit einer auf einem Probentisch aufnehmbaren zylindrischen Abschirmeinheit, einem im Inneren der Abschirmeinheit angeordneten Probenhalter und einem die Abschirmeinheit auf der dem Probentisch zugewandten Seite abschließenden, relativ zum Probenhalter justierbaren Blendenhalter.

13. Zusatzeinheit für ein Rasterelektronenmikroskop mit einer auf einem Probentisch aufnehmbaren zylindrischen Abschirmeinheit, einem im Inneren der Abschirmeinheit angeordneten Detektor, einer eine Öffnung der Abschirmeinheit abschließenden Blende und einem relativ zur Abschirmeinheit oder der Blende senkrecht zur optischen Achse fein justierbaren Probenhalter.
